# EUROPÄISCHE PATENTANMELDUNG

(11) **EP 2 395 365 A1**
(43) Veröffentlichungstag der Anmeldung: **14.12.2011**
(21) Anmeldenummer: 11007174.3
(22) Anmeldetag: 22.04.2009
(51) Int. Cl.: G01R 31/327

(54) **Vorrichtung und Verfahren zum Testen eines elektrischen Schalters nach einem Umbau oder einer Revision**

(62) Teilanmeldung aus: 09005650.8
(71) Anmelder: Omicron electronics GmbH, 6833 Klaus (AT)
(72) Erfinder: Klapper, Ulrich, 6830 Rankweil (AT); Steineke, Caspar, 10625 Berlin (DE)
(74) Vertreter: Banzer, Hans-Jörg

(57) **Zusammenfassung**

Die vorliegende Erfindung stellt ein Verfahren zum Test eines elektrischen Schalters (2) bereit wie er nach einem Umbau oder einer Revision durchgeführt werden muss. Das Verfahren umfasst ein Bestimmen einer Bewegung eines beweglichen Schaltelements (6) des elektrischen Schalters (2) während des Schaltvorgangs, indem eine Beschleunigung erfasst wird, welche auf das bewegliche Schaltelement (6) bei der Bewegung des Schaltelements (6) wirkt, und die Bewegung des Schaltelements (6) in Abhängigkeit der erfassten Beschleunigung bestimmt wird. In Abhängigkeit der bestimmten Bewegung des Schaltelements (6) wird ein Weg-Zeitdiagramm bestimmt, um durch Auswertung des Weg-Zeitdiagramms den Schaltvorgang des elektrischen Schalters (2) zu überprüfen.

## Beschreibung

Die vorliegende Erfindung betrifft Verfahren und Vorrichtungen zum Überprüfen eines Schaltvorgangs eines elektrischen Schalters, insbesondere Verfahren und Vorrichtungen zum Überprüfen von Öffnungs- und Schließvorgängen von elektrischen Höchst-, Hoch- und Mittetspannungsschaltern wie sie nach einem Umbau oder einer Revision eines Schalters durchgeführt werden müssen.

Elektrische Leistungsschalter und Lastschalter, wie z.B. Höchst-, Hoch- und Mittelspannungsschalter, müssen nach einer Neuinstallation, nach einem Umbau oder nach einer Revision geprüft werden, bevor sie wieder in Betrieb genommen werden dürfen. Eine wichtige Prüfung ist dabei die Aufnahme eines so genannten Weg-Zeitdiagramms, um insbesondere zu überprüfen, ob der Öffnungsvorgang oder Schließvorgang des Schalters schnell genug abläuft und ob am Ende eines Weges ein Abbremsen eines beweglichen Teils oder Schaltelements des Schalters in der gewünschten Art und Weise erfolgt.

Gemäß dem Stand der Technik wird dazu zwischen dem beweglichen Schaltelement des Schalters und einem festen Teil des Schalters ein Weg- oder ein Winkelaufnehmer angebracht. Mit Hilfe einer geeigneten Prüfvorrichtung kann damit während des Schaltvorgangs der Weg oder der Winkel über der Zeit aufgezeichnet werden und mit Hilfe des so bestimmten Weg- oder Winkel-Zeitdiagramms können alle notwendigen weiteren Analysen durchgeführt werden. Das Anbringen des Weg- oder Winkelaufnehmers ist verhältnismäßig aufwändig, da die beweglichen Teile des elektrischen Schalters üblicherweise nicht leicht zugänglich sind und häufig sehr wenig Raum zum Anbringen der Aufnehmer vorhanden ist.

Aufgabe der vorliegenden Erfindung ist es daher, verbesserte Verfahren und Vorrichtungen zum Überprüfen eines Schaltvorgangs eines elektrischen Schalters bereitzustellen, welche insbesondere eine Montage vereinfachen und auch bei geringem Raumangebot in der Umgebung der beweglichen Teile des Schalters verwendbar und betreibbar sind.

Gemäß der vorliegenden Erfindung werden diese Aufgaben durch ein Verfahren zum Überprüfen eines Schaltvorgangs eines elektrischen Schalters nach Anspruch 1 und durch eine Vorrichtung zum Überprüfen eines Schaltvorgangs eines elektrischen Schalters nach Anspruch 6 gelöst. Die abhängigen Ansprüche definieren vorteilhafte und bevorzugte Ausführungsformen der Erfindung.

Gemäß der vorliegenden Erfindung wird ein Verfahren zum Überprüfen eines Schaltvorgangs eines elektrischen Schalters bereitgestellt. Das Verfahren umfasst ein Bestimmen einer Bewegung eines beweglichen Schaltelements des elektrischen Schalters während des Schaltvorgangs, indem eine Beschleunigung, welche auf das Schaltelement bei der Bewegung des Schaltelements wirkt, erfasst wird. In Abhängigkeit der erfassten Beschleunigung wird die Bewegung des Schaltelements bestimmt. Die Beschleunigung kann beispielsweise mit einem Beschleunigungssensor, welcher an dem Schaltelement angebracht ist, erfasst werden. Da moderne Beschleunigungssensoren eine sehr kleine Bauform aufweisen, ist ein Anbringen des Beschleunigungssensors und somit das Erfassen der Beschleunigung auch bei beengten Raumverhältnissen möglich. Darüber hinaus wird der Beschleunigungssensor nur an dem Schaltelement angebracht, wohingegen Weg- oder Winkelaufnehmer gemäß dem Stand der Technik an dem Schaltelement und an einem unbeweglichen Teil des elektrischen Schalters angebracht werden müssen, wodurch die Montage des Beschleunigungssensors gegenüber der Montage des Weg- oder Winkelaufnehmers erheblich vereinfacht wird.

Das Bestimmen der Bewegung des beweglichen Schaltelements kann beispielsweise ein Bestimmen einer Geschwindigkeit des Schaltelements während des Schaltvorgangs umfassen. Das Bestimmen der Geschwindigkeit kann beispielsweise durch Integrieren von Beschleunigungswerten der erfassten Beschleunigung bestimmt werden.

Das Bestimmen der Bewegung kann weiterhin ein Bestimmen einer Position des Schaltelements gegenüber einem feststehenden Teil des elektrischen Schalters umfassen. Mit den so bestimmten Informationen über Beschleunigung, Geschwindigkeit und Position des Schaltelements kann der Schaltvorgang, insbesondere ein Öffnungsvorgang und/oder ein Schließvorgang, des elektrischen Schalters genau analysiert werden. Insbesondere kann überprüft werden, ob der Öffnungsvorgang oder Schließvorgang des Schalters schnell genug abläuft und ob am Ende des Vorgangs ein Abbremsen des Schaltelements in der gewünschten Art und Weise erfolgt.

Gemäß der vorliegenden Erfindung wird ein weiteres Verfahren zum Überprüfen eines Schaltvorgangs eines elektrischen Schalters bereitgestellt. Das Verfahren umfasst ein Bestimmen einer Bewegung eines beweglichen Schaltelements des elektrischen Schalters während des Schaltvorgangs, indem eine Position einer optischen Markierung, welche an dem Schaltelement angebracht ist, optisch erfasst wird. Aus der erfassten Position der optischen Markierung wird die Bewegung des Schaltelements bestimmt. Das Anbringen der optischen Markierung an dem beweglichen Schaltelement des elektrischen Schalters erfordert nur einen minimalen Eingriff an dem Schalter und ist daher insbesondere bei sehr beengten Verhältnissen im Bereich des Schalters besonders geeignet. Das optische Erfassen der Position der optischen Markierung kann beispielsweise mit Hilfe einer elektronischen Bilderfassungsvorrichtung, wie z.B. einer Digitalkamera, erfolgen, welche mit Hilfe eines geeigneten Objektivs die Position der optischen Markierungen aus geeigneter Entfernung optisch erfassen kann. Weiterer Vorteil der Bestimmung der Bewegung des beweglichen Schaltelements mit Hilfe der optischen Markierungen ist, dass die optische Markierung die Bewegung des beweglichen Schaltelements nicht beeinflusst, da das Gewicht der optischen Markierung vernachlässigbar gering ist und keine mechanische Kopplung mit beispielsweise einem Weg- oder Winkelaufnehmer gemäß dem Stand der Technik erforderlich ist.

Das Bestimmen der Bewegung des beweglichen Schaltelements kann ein Bestimmen einer Geschwindigkeit des Schaltelements während des Schaltvorgangs und/oder ein Bestimmen einer Position des Schaltelements gegenüber einem feststehenden Teil des elektrischen Schalters umfassen. Mit Hilfe dieser Informationen ist eine genaue Analyse eines Bewegungsablaufs des beweglichen Schaltelements während des Schaltvorgangs möglich.

Gemäß einer Ausführungsform kann die optische Markierung zwei optische Markierungen in einem vorbestimmten Abstand umfassen. Die Bewegung des beweglichen Schaltelements wird in diesem Fall zusätzlich in Abhängigkeit des vorbestimmten Abstands bestimmt. Da der Abstand bekannt ist, können bei dieser Ausführungsform Perspektivenabhängigkeiten, welche durch unterschiedliche Entfernungen und Betrachtungswinkel zwischen der Bilderfassungsvorrichtung und den optischen Markierungen auftreten können, zuverlässig korrigiert werden.

Gemäß einer Ausführungsform werden die vorgenannten Verfahren zur Überprüfung eines Öffnungsvorgangs und/oder eines Schließvorgangs des elektrischen Schalters durchgeführt, indem ein Weg-Zeitdiagramm des beweglichen Schaltelements des elektrischen Schalters aufgenommen wird. Durch Umrechnen von Beschleunigungswerten in Geschwindigkeits- und Ortswerte bzw. durch Umrechnen der Positionen in Geschwindigkeits- und Beschleunigungswerte kann ein letztendlich interessierendes Weg-Zeitdiagramm für den Öffnungsvorgang und/oder den Schließvorgang des elektrischen Schalters auf einfache Art und Weise bestimmt werden.

Gemäß der vorliegenden Erfindung wird weiterhin eine Vorrichtung zum Überprüfen eines Schaltvorgangs eines elektrischen Schalters bereitgestellt. Die Vorrichtung umfasst einen Beschleunigungssensor, welcher an einem beweglichen Schaltelement des elektrischen Schalters angebracht ist. Der Beschleunigungssensor dient zur Erfassung einer Beschleunigung, welche auf das Schaltelement bei einer Bewegung des Schaltelements während des Schaltvorgangs wirkt. Die Vorrichtung umfasst weiterhin eine Verarbeitungseinheit, welche mit dem Beschleunigungssensor gekoppelt ist. Die Verarbeitungseinheit ist ausgestaltet, die Bewegung des Schaltelements während des Schaltvorgangs in Abhängigkeit der erfassten Beschleunigung zu bestimmen. Durch die Verwendung des Beschleunigungssensors zum Aufnehmen der Bewegung des Schaltelements kann die Bewegung des Schaltelements zuverlässig auch bei beengten Verhältnissen in der Umgebung des Schalters und des Schaltelements aufgenommen werden.

Gemäß einer Ausführungsform ist die Verarbeitungseinheit mit dem Beschleunigungssensor über eine drahtlose Verbindung, wie z.B. eine Funkverbindung oder eine optische Verbindung, gekoppelt. Durch die Verwendung der drahtlosen Verbindung wird die Verwendung der Vorrichtung weiter vereinfacht, da keine Leitungen zwischen dem Beschleunigungssensor und der Verarbeitungseinheit verlegt werden müssen.

Gemäß der vorliegenden Erfindung wird eine Vorrichtung zum Überprüfen eines Schaltvorgangs eines elektrischen Schalters bereitgestellt, welche eine an einem beweglichen Schaltelement des Schalters angebrachte optische Markierung, eine Bilderfassungsvorrichtung und eine Verarbeitungseinheit umfasst. Die Bilderfassungsvorrichtung ist derart ausgestaltet, dass sie eine Position der optischen Markierung an dem beweglichen Schaltelement erfassen kann. Die Verarbeitungseinheit ist mit der Bilderfassungsvorrichtung gekoppelt. Die Verarbeitungseinheit ist derart ausgestaltet, dass sie eine Bewegung des Schaltelements während des Schaltvorgangs in Abhängigkeit der erfassten Position der optischen Markierung bestimmen kann.

Die Bilderfassungsvorrichtung kann ferner zum optischen Erfassung einer dreidimensionalen Position der optischen Markierung ausgestaltet sein.

Gemäß einer Ausführungsform umfasst die Vorrichtung weiterhin eine Beleuchtungseinrichtung, welche zum Beleuchten der Markierung mit Licht eines vorbestimmten Wellenlängenbereichs ausgestaltet ist. Die Markierung ist in diesem Fall derart ausgestaltet, dass sie den vorbestimmten Wellenlängenbereich besonders gut reflektiert. Vorzugsweise liegt der vorbestimmte Wellenlängenbereich außerhalb des Bereichs von üblichem Tageslicht. Zusätzlich kann die Bilderfassungsvorrichtung ein Filter umfassen, welches nur Licht in dem vorbestimmten Wellenlängenbereich passieren lässt. Durch die Verwendung eines vorbestimmten Wellenlängenbereichs, vorzugsweise eines möglichst schmalen Wellenlängenbereichs, kann die Zuverlässigkeit der optischen Erfassung erheblich verbessert werden und darüber hinaus eine Bildverarbeitung, welche bei der Bewegungsbestimmung durchgeführt wird, erheblich vereinfacht werden.

Die Beleuchtungseinrichtung kann beispielsweise einen Laser mit einem vorbestimmten Wellenlängenbereich umfassen. Die Beleuchtungseinrichtung kann weiterhin eine Linienlinse umfassen, welche nur einen schmalen Bereich in der Bewegungsrichtung der an dem beweglichen Schaltelement angebrachten Markierung ausleuchtet.

Die Bilderfassungsvorrichtung und die Verarbeitungseinheit können in einem gemeinsamen integrierten Schaltkreis ausgebildet sein. Dadurch kann eine so genannte "On Chip"-Auswertung durchgeführt werden, wodurch eine Datenmenge, welche zwischen der Bilderfassungsvorrichtung und der Verarbeitungseinheit auszutauschen ist, nur lokal auf einem integrierten Schaltkreis übertragen wird. Dadurch ist eine Übertragung großer Datenmengen zwischen abgesetzten Einheiten nicht erforderlich, wodurch eine Erhöhung der Bildabtastungsfrequenz der Bilderfassungsvorrichtung möglich ist und die Positionserfassung erheblich genauer durchgeführt werden kann.

Die vorliegende Erfindung wird nachfolgend unter Bezugnahme auf die Zeichnungen anhand bevorzugter Ausführungsformen erläutert werden.
Fig. 1 zeigt eine schematische Darstellung einer Ausführungsform der vorliegenden Erfindung, welche einen Beschleunigungssensor verwendet.
Fig. 2 zeigt eine schematische Darstellung einer Ausführungsform der vorliegenden Erfindung, welche zwei an einem beweglichen Schaltelement angebrachte Markierungen und eine Bilderfassungsvorrichtung verwendet.

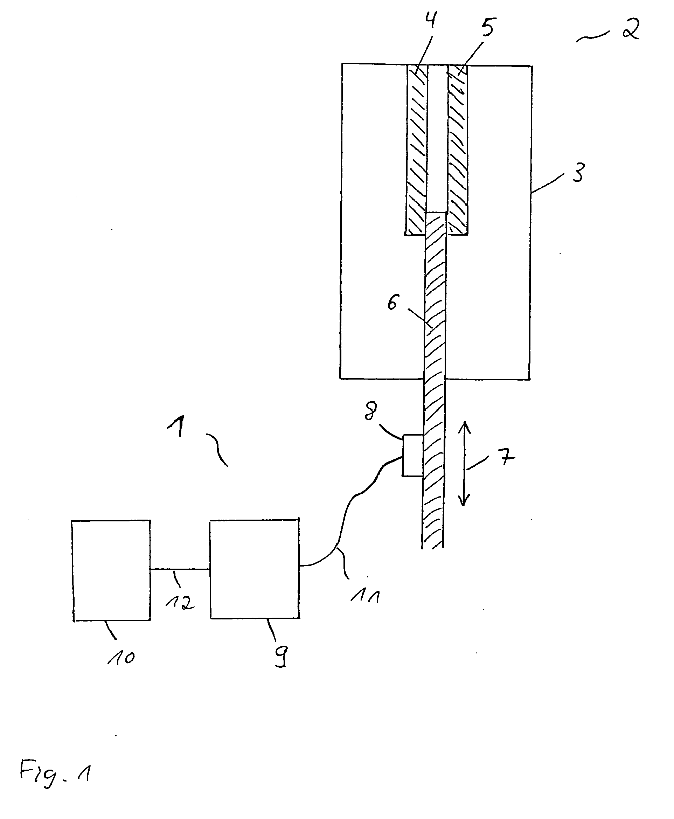

Fig. 1 zeigt eine Vorrichtung 1 zum Überprüfen eines Schaltvorgangs eines elektrischen Schalters 2. Der elektrische Schalter 2 kann beispielsweise ein elektrischer Höchst-, Hoch- oder Mittelspannungsschalter sein. Der elektrische Schalter 2 umfasst eine Schaltkammer 3, in welcher zwei feststehende Kontakte 4, 5 fest mit der Schaltkammer 3 verbunden angeordnet sind. Ein bewegliches Schaltelement 6 des elektrischen Schalters 2 ragt durch eine Öffnung der Schaltkammer 3 in die Schaltkammer 3 derart hinein, dass bei einer Bewegung des beweglichen Schaltelements 6 in einer Bewegungsrichtung 7 ein elektrischer Kontakt zwischen den feststehenden Kontakten 4, 5 und dem beweglichen Schaltelement 6 wahlweise hergestellt oder unterbrochen werden kann.

Die Vorrichtung 1 dient zum Überprüfen der korrekten Funktionsweise des elektrischen Schalters 2. Die Vorrichtung 1 umfasst einen Beschleunigungssensor oder Beschleunigungsaufnehmer 8, eine Beschleunigungserfassungseinheit 9 und eine Verarbeitungseinheit 10. Die Beschleunigungserfassungseinheit 9 ist über eine Verbindung 11 mit dem Beschleunigungssensor 8 gekoppelt. Die Verbindung 11 kann beispielsweise eine drahtgebundene oder eine drahtlose Verbindung sein. Die Verarbeitungseinheit 10 ist über eine weitere Verbindung 12 mit der Beschleunigungserfassungseinheit 9 gekoppelt.

Bei einer Bewegung, z.B. einem Öffnungsvorgang oder einem Schließvorgang, des beweglichen Schaltelements 6 in der Bewegungsrichtung 7 wird eine entsprechende Beschleunigung von dem Beschleunigungssensor 8 erfasst. In Abhängigkeit der Bewegung des beweglichen Schaltelements 6 stellt der Beschleunigungssensor 8 ein beispielsweise analoges oder digitales Signal bereit, welches über die Verbindung 11 zu der Beschleunigungserfassungseinheit 9 übertragen wird. Die Beschleunigungserfassungseinheit 9 bestimmt daraus beispielsweise ein digitales Beschleunigungssignal, welches über die Verbindung 12 zu der Verarbeitungseinheit 10 übertragen wird. In der Verarbeitungseinheit 10 wird die Beschleunigungsinformation in eine Geschwindigkeitsinformation und eine Positions- oder Weginformation umgerechnet. Darüber hinaus kann die Verarbeitungseinheit auch ein Weg-Zeitdiagramm auf der Grundlage der Beschleunigungs-, Geschwindigkeits- und Weginformationen bestimmen.

Der Beschleunigungssensor 8 ist mechanisch nur mit dem beweglichen Schaltelement 6 gekoppelt. Gegenüber einem Weg- oder Winkelaufnehmer gemäß dem Stand der Technik, welcher sowohl mit dem beweglichen Schaltelement 6 als auch einem feststehenden Teil des Schalters 2 mechanisch zu koppeln ist, ist ein Anbringen des Beschleunigungssensors 8 erheblich einfacher möglich als ein Anbringen des Weg- oder Winkelaufnehmers gemäß dem Stand der Technik. Darüber hinaus ist der Beschleunigungssensor 8 in seinen Abmessungen sehr kompakt, so dass er auch bei beengten Raumverhältnissen einsetzbar ist.

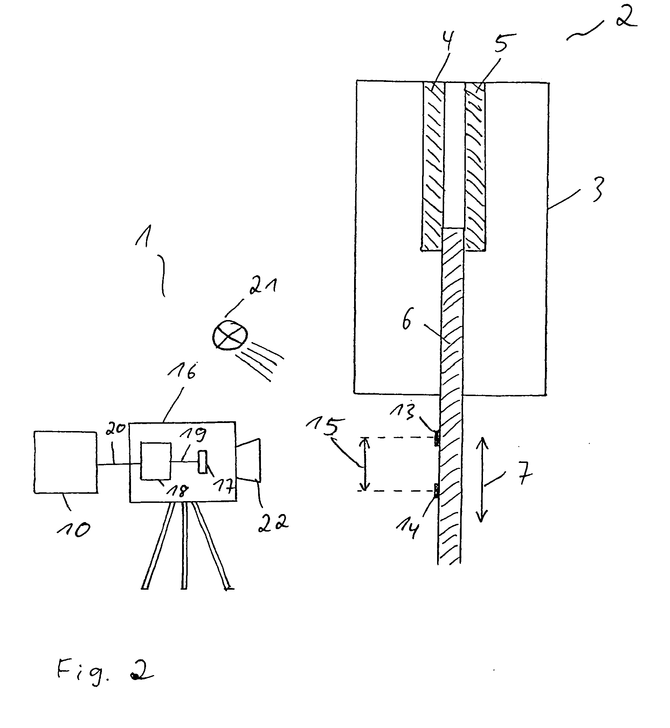

Fig. 2 zeigt eine weitere Ausführungsform einer Vorrichtung 1 zum Überprüfen eines Schaltvorgangs eines elektrischen Schalters 2. Der elektrische Schalter 2 umfasst, wie der im Zusammenhang mit Fig. 1 beschriebene elektrische Schalter 2, eine Schaltkammer 3, in welcher zwei feststehende Kontakte 4, 5 sowie ein bewegliches Schaltelement 6 angeordnet sind. Das bewegliche Schaltelement 6 ist in einer Bewegungsrichtung 7 hin und her bewegbar.

Die in Fig. 2 gezeigte Vorrichtung 1 umfasst zwei optische Markierungen 13, 14, welche in einem vorbestimmten Abstand 15 an dem beweglichen Schaltelement 6 angebracht sind. Die Vorrichtung 1 umfasst weiterhin eine Bilderfassungsvorrichtung 16 und eine Verarbeitungseinheit 10. Die Bilderfassungsvorrichtung 16 umfasst einen optischen Sensor 17, beispielsweise einen so genannten CCD-Sensor, und eine Bilderfassungseinheit 18. Der optische Sensor 17 ist über eine Verbindung 19 mit der Bilderfassungseinheit 18 gekoppelt. Die Bilderfassungseinheit 18 ist über eine Verbindung 20 mit der Verarbeitungseinheit 10 gekoppelt. Die Bilderfassungsvorrichtung 16 kann beispielsweise eine Digitalkamera mit einem Stativ umfassen. Die Vorrichtung 1 umfasst weiterhin eine Lichtquelle 21, welche beispielsweise als ein Scheinwerfer oder als ein Laser ausgebildet sein kann. Die Bilderfassungsvorrichtung 16 ist derart angeordnet, dass sie über ein Objektiv 22 der Bilderfassungsvorrichtung 16 ein Abbild des beweglichen Schaltelements 6 mit den daran angebrachten optischen Markierungen 13, 14 erfassen kann. Der optische Sensor 17 erfasst das Abbild der optischen Markierungen 13, 14 auf dem beweglichen Schaltelement 6 und überträgt die Bildinformationen an die Bilderfassungseinheit 18. Die Bilderfassungseinheit 18 stellt der Verarbeitungseinheit 10 entsprechende Digitalbilder mit einer vorbestimmten Bildwiederholfrequenz von beispielsweise 5000 Bildern pro Sekunde oder 10000 Bildern pro Sekunde zur Verfügung. Die Verarbeitungseinheit 10 analysiert die empfangenden digitalen Bilder und bestimmt die Positionen der optischen Markierungen 13, 14. Da die Verarbeitungseinheit 10 eine Information über den vorbestimmten Abstand 15 zwischen den optischen Markierungen 13, 14 aufweist, ist es auf einfache Art und Weise möglich, aus einer Bildfolge von digitalen Bildern eine Bewegung der optischen Markierungen 13, 14 sowie deren Position und Geschwindigkeit zu bestimmen.

Durch eine geeignete Beleuchtung des beweglichen Schaltelements mit den daran angebrachten optischen Markierungen 13, 14 mit Hilfe einer Lichtquelle 21 mit einem schmalbandigen Wellenlängenspektrum und einem dazu passenden Filter vor der Bilderfassungsvorrichtung 16 kann der Rechenaufwand zur Bestimmen der Position der Markierungen 13, 14 erheblich reduziert werden. Weiterhin können die Markierungen 13, 14 eine vorbestimmte Form, z.B. rund, und eine vorbestimmte Farbe aufweisen. Dadurch kann die Bildverarbeitung in der Verarbeitungseinheit 10 weiter vereinfacht werden. Durch das Anbringen der optischen Markierungen 13, 14 mit vorbestimmtem Abstand 15 kann die Erfassung der optischen Markierungen 13, 14 durch die Bilderfassungsvorrichtung 16 unter verschiedenen Winkeln oder Perspektiven der Bilderfassungsvorrichtung 16 erfolgen. Zusätzlich können an feststehenden Teilen des Schalters weitere Markierungen angebracht werden, um eine Bewegung des beweglichen Schaltelements bezogen auf die feststehenden Teile des Schalters zu bestimmen.

Als Lichtquelle 21 eignet sich vorzugsweise eine schmalbandige Lichtquelle, wie z.B. eine Laserlichtquelle. Darüber hinaus kann die Lichtquelle 21 eine Linienlinse umfassen, welche nur einen schmalen Bereich entlang der Bewegungsrichtung 7 im Bereich des beweglichen Schaltelements 6 ausleuchtet.

Die Lichtquelle 21 kann beispielsweise nur für die Zeit, in der der Schalter 2 betätigt wird, eingeschaltet werden. Das Ein- und Ausschalten der Lichtquelle 21 kann beispielsweise durch ein Signal erfolgen, welches den Schaltvorgang des Schalters 2 einleitet. Die Beleuchtung kann beispielsweise einige Sekunden länger leuchten als der Schaltvorgang dauert. Da die Lichtquelle 21 üblicherweise eine sehr begrenzte Lebensdauer aufweist, wird durch das Einschalten der Lichtquelle in Abhängigkeit des Schaltvorgangs die Lebensdauer der Lichtquelle erheblich verlängert.

Der optische Sensor 17, die Bilderfassungseinheit 18 und die Verarbeitungseinheit 10 können in einer integrierten Einheit auf einem Chip ausgebildet werden. Da bei einer Bildverarbeitung üblicherweise große Datenmengen übertragen werden, wird diese Datenübertragung auf den Chip begrenzt, wodurch eine erheblich schnellere Bildverarbeitung erreicht werden kann. Dadurch kann die Bildwiederholfrequenz erhöht werden und somit die Messung genauer und feingranularer durchgeführt werden. Eine Ausgabe der gesamten Bildinformation, beispielsweise um die korrekte Einstellung der Bilderfassungsvorrichtung 16 zu überprüfen, ist während der eigentlichen Messung des Schaltvorgangs nicht erforderlich, sondern es genügt, die Bewegungsinformationen der optischen Markierungen 13, 14 zu übertragen.

Schließlich kann die Auswertung der Bildinformationen ebenso wie die Lichtquelle in Abhängigkeit des Schaltvorgangs aktiviert werden. Die Bildverarbeitung wird aktiviert, sobald ein Ein- oder Ausschaltvorgang des Schalters 2 eingeleitet wird. Die Bildverarbeitung wird beendet, wenn der Schaltvorgang abgeschlossen ist, eine vorbestimmte Zeit vergangen ist oder die Verarbeitungseinheit 10 erkannt hat, dass das bewegliche Schaltelement 6 zur Ruhe gekommen ist.

## Patentansprüche

1. Verfahren zum Überprüfen eines Schaltvorgangs eines elektrischen Schalters, umfassend:
Bestimmen einer Bewegung eines beweglichen Schaltelements (6) des elektrischen Schalters (2) während des Schaltvorgangs durch
- Erfassen einer Beschleunigung, welche auf das Schaltelement (6) bei der Bewegung des Schaltelements (6) wirkt,
- Bestimmen der Bewegung des Schaltelements (6) in Abhängigkeit der erfassten Beschleunigung, und
- Bestimmen eines Weg-Zeitdiagramms in Abhängigkeit der bestimmten Bewegung des Schaltelements (6), um durch Auswertung des Weg-Zeitdiagramms den Schaltvorgang des elektrischen Schalters (2) zu überprüfen.

2. Verfahren nach Anspruch 1, wobei der elektrische Schalter einen elektrischen Leistungsschalter umfasst, **dadurch gekennzeichnet, dass** das Verfahren nach einem Umbau oder einer Revision zum Test des elektrischen Leistungsschalters durchgeführt wird.

3. Verfahren nach Anspruch 1 oder 2, **dadurch gekennzeichnet, dass** das Bestimmen der Bewegung ein Bestimmen einer Geschwindigkeit des Schaltelements (6) während des Schaltvorgangs umfasst.

4. Verfahren nach einem der vorhergehenden Ansprüche, **dadurch gekennzeichnet, dass** das Bestimmen der Bewegung ein Bestimmen einer Position des Schaltelements (6) gegenüber einem feststehenden Teil (3-5) des elektrischen Schalters (2) umfasst.

5. Verfahren nach einem der vorhergehenden Ansprüche, **dadurch gekennzeichnet, dass** das Verfahren zur Überprüfung eines Öffnungsvorgangs und/oder eines Schließvorgangs des elektrischen Schalters (2) durch Aufnahme des Weg-Zeitdiagramms des beweglichen Schaltelements (6) des elektrischen Schalters (2) durchgeführt wird.

6. Vorrichtung zum Überprüfen eines Schaltvorgangs eines elektrischen Schalters, umfassend:
- einen Beschleunigungssensor (8), welcher an einem beweglichen Schaltelement (6) des elektrischen Schalters (2) zur Erfassung einer Beschleunigung, welche auf das Schaltelement (6) bei einer Bewegung des Schaltelements (6) während des Schaltvorgangs wirkt, angebracht ist, und
- eine Verarbeitungseinheit (10), welche mit dem Beschleunigungssensor (8) gekoppelt ist und ausgestaltet ist, die Bewegung des Schaltelements (6) während des Schaltvorgangs in Abhängigkeit der erfassten Beschleunigung zu bestimmen und ein Weg-Zeitdiagramm in Abhängigkeit der bestimmten Bewegung des Schaltelements (6) zu bestimmen, um eine Überprüfung des Schaltvorgangs des elektrischen Schalters (2) durch Auswertung des Weg-Zeitdiagramms zu ermöglichen.

7. Vorrichtung nach Anspruch 6, **dadurch gekennzeichnet, dass** die Verarbeitungseinheit (10) über eine drahtlose Funkverbindung (11) mit dem Beschleunigungssensor (8) gekoppelt ist.

8. Vorrichtung nach Anspruch 6 oder 7, **dadurch gekennzeichnet, dass** die Vorrichtung (1) zur Durchführung des Verfahrens nach einem der Ansprüche 1-5 ausgestaltet ist.
